(19)

**Europäisches Patentamt**
**European Patent Office**
**Office européen des brevets**

(11) EP 2 890 834 B1

(12) **EUROPÄISCHE PATENTSCHRIFT**

(45) Veröffentlichungstag und Bekanntmachung des Hinweises auf die Patenterteilung:
**13.06.2018 Patentblatt 2018/24**

(21) Anmeldenummer: **13756440.7**

(22) Anmeldetag: **29.08.2013**

(51) Int Cl.:
*C30B 13/28* (2006.01)     *G05B 13/04* (2006.01)

(86) Internationale Anmeldenummer:
**PCT/EP2013/067893**

(87) Internationale Veröffentlichungsnummer:
**WO 2014/033212 (06.03.2014 Gazette 2014/10)**

(54) **MODELLPRÄDIKTIVE REGELUNG DES ZONENSCHMELZ-VERFAHRENS**

MODEL PREDICTIVE CONTROL OF THE ZONE-MELTING PROCESS

COMMANDE PRÉDICTIVE DE LA MÉTHODE DE LA ZONE FLOTTANTE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.08.2012 DE 102012108009**

(43) Veröffentlichungstag der Anmeldung:
**08.07.2015 Patentblatt 2015/28**

(73) Patentinhaber: **Topsil GlobalWafers A/S 3600 Frederikssund (DK)**

(72) Erfinder:
• **WERNER, Nico
  10365 Berlin (DE)**
• **WÜNSCHER, Michael
  53301 Grafschaft-Geisdorf (DE)**

(74) Vertreter: **AWA Denmark A/S
Strandgade 56
1401 Copenhagen K (DK)**

(56) Entgegenhaltungen:
**EP-A1- 0 821 082     DE-A1- 2 659 194
US-A- 3 757 071**

• **SATUNKIN ET AL: "Modelling the dynamics and control design for Czochralski, Liquid Encapsulated Czochralski and Floating Zone processes", PROGRESS IN CRYSTAL GROWTH AND CHARACTERIZATION OF MATERIALS, ELSEVIER PUBLISHING, BARKING, GB, Bd. 56, Nr. 1-2, 1. März 2010 (2010-03-01), Seiten 1-121, XP027273599, ISSN: 0960-8974 [gefunden am 2010-03-01]**
• **G. BÄRWOLFF ET AL: "Optimization of semiconductor melts", ZAMM, Bd. 86, Nr. 6, 1. Juni 2006 (2006-06-01), Seiten 423-437, XP055086439, ISSN: 0044-2267, DOI: 10.1002/zamm.200410247**
• **GUENTER BAERWOLFF ET AL: "BOUNDARY CONTROL OF SEMICONDUCTOR MELTS", PROCEEDINGS OF ALGORITMY 2005, 18. März 2005 (2005-03-18), Seiten 64-72, XP055088006,**
• **GONIK ET AL: "Development of a model for on-line control of crystal growth by the AHP method", JOURNAL OF CRYSTAL GROWTH, ELSEVIER, AMSTERDAM, NL, Bd. 303, Nr. 1, 10. April 2007 (2007-04-10), Seiten 180-186, XP022025696, ISSN: 0022-0248, DOI: 10.1016/J.JCRYSGRO.2006.12.053**

**EP 2 890 834 B1**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

# EP 2 890 834 B1

## Beschreibung

Das Zonenschmelzverfahren ist ein Verfahren zur Herstellung von hochreinen einkristallinen Werkstoffen. Andere Bezeichnungen für Zonenschmelzen sind Floating-Zone-Verfahren (FZ), Fließzonenverfahren, Zonenreinigungoder Zonenfloating. Das vertikale tiegelfreie Zonenschmelzverfahrenist ein Züchtungsverfahren insbesondere zur Herstellung von hochreinem einkristallinem Silizium.

Das von Theuerer [US Patent 3,060,123 (1952)], Keck, Golay und Emeis entwickelte tiegelfreie Zonenschmelzverfahren verwendet zum Aufschmelzen und Aufrechterhalten der Schmelzzone unter Schutzgasatmosphäre eine Induktionsheizung. Durch die kontaktlose Heizquelle werden höchste Reinheitsanforderungen erfüllt. Im Vergleich zu Tiegelverfahren bietet das Zonenschmelzverfahren, da es tiegellos abläuft, den Vorteil, dass keine Verunreinigungen aus dem Tiegelmaterial austreten können.

Das polykristalline Vorratsmaterial (Vorratsstab) wird beim Zonenschmelzverfahrendurch eine kreisförmige Öffnung innerhalb der Induktionsspulehindurchgefahren und dabei geschmolzen. Ab einem bestimmten Abstand unterhalb der Induktionsspulekristallisiert die Schmelze zu einem versetzungsfreien Einkristall. Die Induktionsspule wird von einem Generator mit einer Frequenz zwischen 2,5 und 3 MHz gespeist. Für das Wachsen von größeren Kristallen (>30 mm) kommt die Nadelöhr-Technik zum Einsatz, d.h., dass der Durchmesser des Vorratsmaterials und des Kristalls größer sind als der Durchmesser des Induktorlochs, um genügend Leistung ins Zentrum des Kristalls zu bringen und somit ein Zusammenfrieren zu verhindern bzw. die Kapillarstabilität zu gewährleisten.

Das Reinigungsvermögen beim Zonenschmelzverfahrenberuht auf der Tatsache, dass Verunreinigungen in der Schmelze ein niedrigeres chemisches Potential haben als im Festkörper und somit aus einem Großteil desKristalls entfernt werden können. Die Menge, die im Kristall eingebaut wird, ist unter anderem abhängig von der Art der Verunreinigung und der Erstarrungsgeschwindigkeit. Heutzutage werden mittels Zonenschmelzverfahrens Einkristalle mit einem Durchmesser bis zu 200 mm und einer Länge von mehreren Metern industriell hergestellt.

In der industriellen Produktion ist die Automatisierung des Zonenschmelzverfahrens über empirisch eingestellte PID-Regler umgesetzt. Als Stellglieder fungieren die Hubgeschwindigkeit und die Heizleistung. Diese Regler erzielen bei immer gleichen Prozessbedingungen aufgrund der umfangreichen Prozesskenntnisse gute Ergebnisse. Jedoch beim Einsatz neuer bzw. verschiedener Anlagenkomponenten, der Züchtung immer größerer Kristalle und bei der Automatisierung anderer Prozessphasen gelangen die konventionellen PID-Regler an ihre Einsatzgrenzen.

Die Offenlegungsschrift US3757071 beschreibt ein Verfahren zur Durchmesserregelung beim tiegellosen Zonenschmelzen von Halbleiterstäben, welches Bildsignale zur Prozesssteuerung verwendet.

Ein automatisch geregeltes Zonenschmelzverfahren zur Herstellung von einkristallinen Stäben ist in der Offenlegungsschrift DE2659194 beschrieben. Dabei werden Ist-Wert-Signale von Detektoren zur automatischen Regelung der Prozessparameter verwendet.

In der Offenlegungsschrift EP0821082 wird ein vollständiges vorhersehendes Mehrgrößensteuersystem zur Regulierung von verschiedenen Einkristallwachstumsprozessen offenbart.

Der Artikel "Modelling the dynamics and control design for Czochralski, Liquid Encapsulated Czochralski and Floating Zone processes", von G. Satunkin, erschienen in Progress in Crystal Growth and Characterization of Materials, Bd. 56 (2010) 1-121, befasst sich mit mathematischen Modellsystemen zur Verwendung in automatischen Steuersystemen von Kristallisationsprozessen.

J Aufgabe der vorliegenden Erfindung ist die Bereitstellung eines Verfahrens zur geregelten Erzeugung von kristallinen Formkörpern im tiegelfreien Zonenschmelzverfahren, welches die oben genannten Nachteile überwindet.

Die Aufgabe wurde gelöst mit dem in Anspruch 1 definierten Verfahren. In einer Ausführungsform ist mindestens ein Soll- und prädizierter Verlaufs-Wert der Systemzustände ein Wertebereich, wobei mindestens eine Anforderung an einer unteren- oder oberen Grenze des Systemzustandswertebereichs bei Veränderung der Stellgröße berücksichtigt wird.

In einer Ausführungsform umfasst mindestens eine Stellgröße einen Wertebereich, wobei bei der Veränderung der Stellgröße mindestens eine Anforderung an einer unteren- oder oberen Grenze des Stellgrößenwertebereichs berücksichtigt wird.

Vorzugsweise ist der kristalline Formkörper ein Silizium-Einkristall, d.h. das Verfahren wird bevorzugt für das Zonenschmelzen von Silizium und die Erzeugung von Silizium-Einkristallen eingesetzt.

Einem Leitsystem werden über eine Computerschnittstelle die berechneten Stellgrößen übergeben sowie die Ist-Größen abgefragt. Sie sorgt für die technische Umsetzung der Kommunikation mit der Zonenschmelz-Anlage.

Die Grundidee der modellprädiktiven Regelung ist das Auffinden einer optimalen Abfolge von Stellgrößen $u(k)$, $u(k + 1)...u(k + H_u)$, so dass ein bestimmtes Kriterium optimal erfüllt wird. Hierfür wird das zukünftige Verhalten des Systems aufgrund eines Prozessmodells vorhergesagt (prädiziert) und anhand einer Kostenfunktion (auch als Gütefunktional oder Gütemaß bezeichnet) bewertet.

Diese Kostenfunktion kann u.a. die Abweichung des prädizierten Systemzustands $x$ von der erwünschten Sollvorgabe $r$ beinhalten. Ziel ist es nun, eine Stellgrößenabfolge so zu finden, dass diese Kostenfunktion minimal wird.

Die Suche nach den optimalen Stellgrößen berücksichtigt die Systembeschränkung, z.B. obere und untere Grenzen für die Systemzustände $\underline{x}$ und Stellgrößen $\underline{u}$. Dies ist ein großer Vorteil der modellprädiktiven Regelung im Vergleich zu den klassischen Regelverfahren, wo das Wissen über Systembeschränkungen nicht direkt in den Reglerentwurf einfließt. Die Berechnung der prädizierten Systemzustände $\underline{x}$ erfolgt für einen endlichen Prädiktionshorizont $H_x$. Die Anzahl der veränderlichen Stellgrößen ist durch den Stellhorizont $H_u$ festgelegt. Liegt der Stellhorizont $H_u$ unter dem Prädiktionshorizont $H_x$, so wird im Allgemeinen die letzte Stellgröße $\underline{u}$ über den restlichen Prädiktionshorizont konstant gehalten. Ein großer Prädiktionshorizont im Vergleich zum Stellhorizont erzeugt in den meisten Fällen ein besseres Verhalten bezüglich der Stabilität des Systems, da die Auswirkung einer Stellgrößenänderung erst viel später im System erkennbar sein kann.

Die Parametrisierung der Stellgrößen kann mittels linearer Rampenfunktionen (First-Order-Hold) zwischen zwei Abtastschritten erfolgen oder alternativ können auch stückweise konstante Stellgrößen (Zero-Order-Hold bzw. Treppenfunktion) innerhalb eines Abtastschritts k Verwendung finden.

Da aufgrund von Systemstörungen und Modellungenauigkeiten die Prädiktion vom realen Verhalten des Systems abweicht, wird nicht die gesamte berechnete Stellgrößenabfolge umgesetzt, sondern nur die erste Stellgröße als Eingang für das System genutzt. Nach jedem Abtastschritt erfolgt eine erneute Berechnung einer optimalen Stellgrößenabfolge basierend auf dem aktuellen gemessenen Systemzustand. Können nicht alle Systemzustände direkt gemessen werden, so wird teilweise ein Zustandsbeobachter eingesetzt, mit dem eine indirekte Messung erfolgt.

Für die Regelung des Zonenschmelz-Verfahrens wird die folgende Kostenfunktion verwendet:

$$J = \sum_{k=1}^{H_x} \boldsymbol{W_x} \cdot (r(k) - x(k))^2 + \sum_{k=1}^{H_u} \boldsymbol{W_u} \cdot (u(k) - u(k-1))^2 + \sum_{k=1}^{H_p} \boldsymbol{W_p} \cdot f_p(x(k))^2$$

Die Kostenfunktion $J$ besteht aus drei Termen. Term 1: Hier wird die quadratische Abweichung zwischen der Sollvorgabe $r$ und dem prädizierten Systemzustand $x$ für alle Zeitpunkte $k$ innerhalb des Zeithorizonts $H_x$ aufsummiert und mit dem Gewichtungsfaktor $W_x$ multipliziert. Term 2: Hier erfolgt eine über den Zeithorizont $H_u$ durchgeführte Summation der quadratischen Stellgrößenänderung zwischen dem Zeitpunkt $k$ und dem vorherigen Zeitpunkt $k$ - 1, gewichtet mit $W_u$. Term 3: Dieser Term berücksichtigt die Vorgaben für die unteren und oberen Grenzen der Systemzustände $x$. Summiert wird der Funktionswert der sogenannten Penalty Funktion $f_p(x)$.

Die Forderung für Stellgrößengrenzen $u_{min}$ und $u_{max}$ werden direkt durch das numerische Optimierungsverfahren zum minimieren der Kostenfunktion $J$ berücksichtigt. Mittels der Gewichtungsfaktoren $W_x$, $W_u$ und $W_p$ können die unterschiedlichen vorkommenden Einheiten der Systemzustände und Stellgrößen, wie z.B. $mm, cm^3, °, kW$ und $mm/min$, berücksichtigt, sowie der Einfluss auf die Kostenfunktion $J$ einzeln verstärkt bzw. abgeschwächt werden.

Durch die Vorhersage des Systemverhaltens mittels eines mathematischen Modells werden für das Zonenschmelzverfahren aus den relevanten Größen über eine Optimierungsmethode die für die Prozess-Automatisierung notwendigen Stellgrößen berechnet. Das auf Differentialgleichungen basierende Modell erlaubt die Berechnung der Stellgrößen mittels handelsüblichen Computern in wenigen Sekunden. Alle Berechnungen laufen in Echtzeit ab, d.h. es werden keine offline berechneten und eventuell interpolierten Werte benötigt. Die Regelung hat zum Ziel, den vollständigen Züchtungsprozess in allen Züchtungsphasen (Dünnhalsphase→Konusphase→Zylinderphase → Abzugsphase) zu automatisieren, um einen Kristall unter definierten Wachstumsbedingungen mit einer definierten axialen Form zu erzeugen. Dadurch wird der Operator während des Züchtungsprozesses entlastet und kann sich hierdurch speziell auf Havarien konzentrieren bzw. die Produktivität durch die Überwachung mehrerer Anlagen erhöhen.

Generell wird das dynamische Verhalten des Zonenschmelzverfahrens unter Berücksichtigung fundamentaler physikalischer Aspekte in der mathematischen Form

$$\underline{\dot{x}}(t) = f(t, \underline{x}(t), \underline{u}(t), \underline{\Theta}) \text{ mit } \underline{x}(0) = \underline{x}_0$$

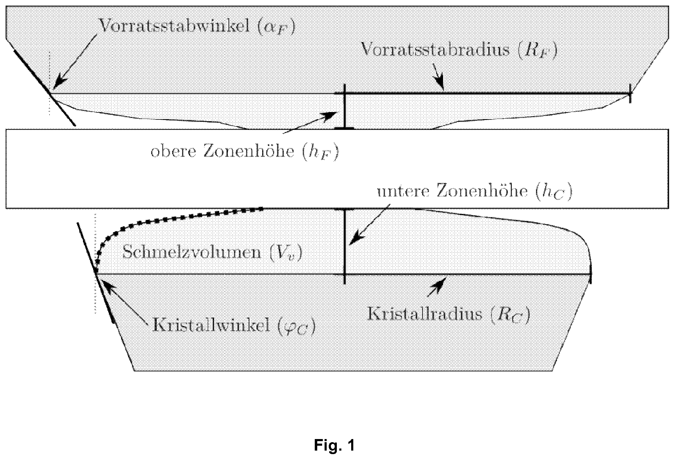

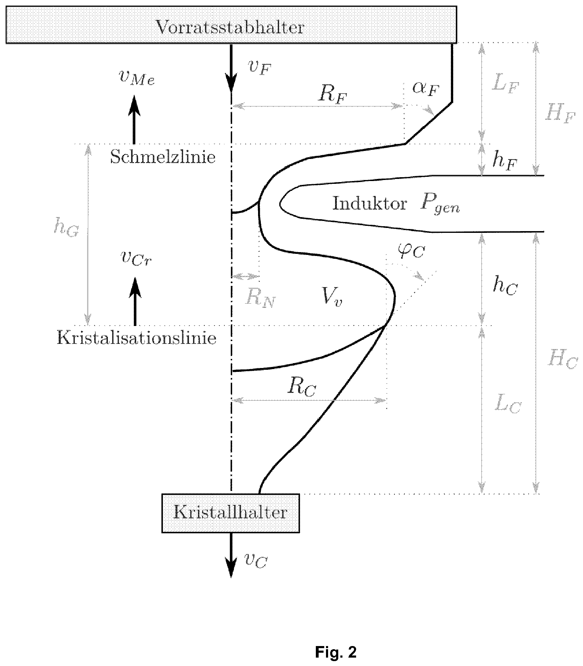

beschrieben, wobei die Funktion f ein Verhältnis zwischen den zeitlichen Ableitungen der Systemzustandswerte $\underline{x}'(t)$ und der Zeit t, den Zustandsvariablen $\underline{x}(t)$ und den Stellgrößen $\underline{u}(t)$ liefert. Die Elemente von $\underline{\Theta}$ stellen Modellparameter dar. Das Zonenschmelzverfahren ist angleichbar über die Stellgrößen Generatorleistung ($P_{Gen}$), Vorratsstab(hub)geschwindigkeit ($v_F$) und Kristall(hub)geschwindigkeit ($v_C$). Die Systemzustandswerte sind Vorratsstabradius ($R_F$), Kristallradius ($R_C$), obere Zonenhöhe ($h_F$), untere Zonenhöhe ($h_C$), (sichtbares) Schmelzvolumen ($V_V$), Geschwindigkeit der Abschmelzfront ($v_{Me}$), Geschwindigkeit der Kristallisationsfront ($v_{Cr}$), Kristallwinkel ($\varphi_C$), Winkel am Vorratsstab ($\alpha_F$) und Induktorleistung ($P_{ind}$) (vgl. Fig. 1 und 2). Erfindungsgemäß wird mindestens ein Soll-Systemzustandswert oder - bereich von $\pm$ 10% um den Soll-Systemzustandswert, ausgewählt aus Vorratsstabsradius ($R_F$), Kristallradius ($R_C$), obere Zonenhöhe ($h_F$), untere Zonenhöhe ($h_C$), (sichtbares) Schmelzvolumen ($V_V$), Geschwindigkeit der Abschmelzfront ($v_{Me}$), Geschwindigkeit der Kristallisationsfront ($v_{Cr}$), Kristallwinkel ($\varphi_C$), Induktorleistung ($P_{ind}$) und Winkel am Vorratsstab

($\alpha_F$)modellbasiert ermittelt. Gleiches gilt für die prädizierten Werte der Systemzustände.

Für einen gegebenen Anfangszustand $\underline{x}_0$ und eine vorgegebene Sequenz der Stellgrößen $\underline{u}(t)$ kann die Zeitabhängigkeit der Zustandswerte $\underline{x}(t)$ unter Verwendung eines numerischen Integrationsverfahrens ähnlich Runge-Kutta (z.B. 4. Ordnung) ermittelt werden. Hierbei sind zwei fundamentale physikalische Gesetze die Basis der Modellierung: der Masseerhaltungssatz und die Konsistenzbedingung zwischen dem Winkel (Vorratsstab/Schmelze) und dem sich ändernden Radius (Vorratsstab / Kristall). Weiterhin wird ein heuristischer Ansatz verwendet, um den thermodynamischen Einfluss der Generatorleistung zu berücksichtigen.

Das erfindungsgemäß zugrunde liegende Modell umfasst die folgenden Gleichungen:

$$\dot{x}_1 : \frac{d}{dt}(R_F) = v_{Me} \cdot tan(\alpha_F)$$

$$\dot{x}_2 : \frac{d}{dt}(R_C) = v_{Cr} \cdot tan(\varphi_C)$$

$$\dot{x}_3 : \frac{d}{dt}(h_F) = v_{Me} - v_F$$

$$\dot{x}_4 : \frac{d}{dt}(h_C) = v_C - v_{Cr}$$

Weiterhin kanndie folgende Gleichung umfasst sein:

$$\dot{x}_5 : \frac{d}{dt}(V_v) = \frac{\rho_S}{\rho_M}(\pi R_F^2 v_{Me} - \dot{V}_{mf}) - \frac{\rho_S}{\rho_M}\pi R_C^2 v_{Cr} - \frac{\rho_M - \rho_S}{\rho_M}\dot{V}_h$$

mit

$$\dot{V}_{mf} = a_{mf}\frac{\pi}{3}\Big(\dot{h}_F(R_F^2 + R_F R_N + R_N^2) + h_F(2R_F + R_N)\dot{R}_F\Big)$$

$$\dot{V}_h = \dot{R}_C\Big(a_1 + 2a_2(R_C - a_0) + 3a_3(R_C - a_0)^2\Big) \text{ für } R_c > a_0 \text{ sonst } 0$$

wobei die Parameter

$\rho_M$ : Dichte geschmolzenes Material [$\rho Si_M$ = 2530 kg/m$^3$]
$\rho_s$ : Dichte des festen Materials [$\rho Si_S$ = 2340 kg/m$^3$]
$a_{mf}$ : Skalierungsfaktor im Bereich von 0 bis 3 (vorzugsweise 1)
$R_N$ : Radius des Schmelzhalses von 1 bis 40 mm (vorzugsweise 10 mm)
$a_0$ : statischer Kennlinienfaktor von8 bis 20 mm (vorzugsweise 14 mm)
$a_1$ : statischer Kennlinienfaktor von400 bis 700 mm$^2$(vorzugsweise 592,94 mm$^2$)
$a_2$ : statischer Kennlinienfaktor von -50 bis -10 mm (vorzugsweise -27,68 mm)
$a_3$ : statischer Kennlinienfaktor von 1 bis4(vorzugsweise 2,15) sind.

Weiterhin kann die folgende Gleichung umfasst sein:

$$\dot{x}_6 : \frac{d}{dt}(v_{Me}) = p_F \dot{P}_{ind} \cdot (R_F)^{w_F} \cdot \left(f_0 - \frac{f_0}{f_1}h_F\right)$$
$$+ p_F P_{ind} \cdot w_F \dot{R}_F (R_F)^{w_F - 1} \cdot \left(f_0 - \frac{f_0}{f_1}h_F\right)$$
$$+ p_F P_{ind} \cdot (R_F)^{w_F} \cdot \left(-\frac{f_0}{f_1}\dot{h}_F\right)$$

wobei die Parameter

$f_0$ (0,001 bis 30 mm), $f_1$ (0,001 bis 30 mm), $p_F$ (0,00001 bis 2 (kWs)$^{-1}$), $w_F$ (0 bis 2, dimensionslos) individuelle Modellparameter bedeuten.

Weiterhin kann die folgende Gleichung umfasst sein:

$$\dot{x}_7 : \frac{d}{dt}(v_{Cr}) = -p_C \dot{P}_{ind} \cdot (R_C)^{w_C} \cdot \left(c_0 - \frac{c_0}{c_1}h_C\right)$$
$$- p_C P_{ind} \cdot w_C \dot{R}_C (R_C)^{w_C - 1} \cdot \left(c_0 - \frac{c_0}{c_1}h_C\right)$$
$$- p_C P_{ind} \cdot (R_C)^{w_C} \cdot \left(-\frac{c_0}{c_1}\dot{h}_C\right)$$

wobei die Parameter $c_0$ (0,001 bis 30 mm), $c_1$ (0,001 bis 30 mm), $p_C$ (0,00001 bis 2 (kWs)$^{-1}$), $w_C$ (0 bis 2, dimensionslos)individuelle Modellparameter bedeuten.

Weiterhin kann die folgende Gleichung umfasst sein:

$$\dot{x}_8 : \frac{d}{dt}(\varphi_C) = a_V \cdot k_V \cdot \dot{V}_v + a_R \cdot k_R \cdot \dot{R}_C + a_h \cdot k_h \cdot \dot{h}_C$$

wobei die Parameter

$a_V$ : ein Winkelkorrekturfaktor = 0 bis 3 (vorzugsweise 1,4)
$a_R$ : ein Winkelkorrekturfaktor = 0 bis 3 (vorzugsweise 1,9)
$a_h$ : ein Winkelkorrekturfaktor = 0 bis 3 (vorzugsweise 1,3)
$k_V$ : ein vom Kristallradius $R_C$ abhängiger Faktor zwischen 3 und 0,0001°/mm$^3$ bei $R_C$ zwischen 1 und 100 mm
$k_R$ : ein vom Kristallradius $R_C$ abhängiger Faktor zwischen -80 und -1°/mm bei $R_C$ zwischen 1 und 100 mm
$k_h$ : ein vom Kristallradius $R_C$ abhängiger Faktor zwischen -60 und -0,01°/mm bei $R_C$ zwischen 1 und 100 mm

sind.

Exemplarische Werte der Faktoren $k_V$, $k_R$ und $k_h$ für Radien des Kristalls zwischen 2 und 70 mm sind nachfolgend in Tabelle 1 dargestellt.

**Tab. 1**

| $R_C$ [mm] | $k_V$ [°/mm$^3$] | $k_R$ [°/mm] | $k_h$ [°/mm] |
|---|---|---|---|
| 2 | 2,45000 | -69,520 | -50,000 |
| 4 | 0,56950 | -49,470 | -42,750 |
| 6 | 0,23100 | -37,700 | -35,500 |
| 10 | 0,08080 | -29,000 | -24,000 |
| 14 | 0,04167 | -22,867 | -17,000 |
| 48 | 0,02564 | -18,800 | -14,714 |
| 22 | 0,01632 | -15,680 | -12,429 |
| 26 | 0,01124 | -13,120 | -10,143 |

(fortgesetzt)

| $R_C$ [mm] | $k_V$ [°/mm³] | $k_R$ [°/mm] | $k_h$ [°/mm] |
|---|---|---|---|
| 30 | 0,00820 | -10,800 | -7,857 |
| 34 | 0,00636 | -9,120 | -5,571 |
| 38 | 0,00506 | -8,040 | -4,100 |
| 42 | 0,00410 | -7,040 | -3,140 |
| 46 | 0,00336 | -6,080 | -2,500 |
| 50 | 0,00280 | -5,600 | -2,100 |
| 60 | 0,00140 | -5,000 | -1,100 |
| 70 | 0,00140 | -5,000 | -1,100 |

Weiterhin können die folgenden Gleichungen umfasst sein:

$$\dot{x}_9 : \frac{d}{dt}(P_{tnd}) = \frac{1}{\tau_P}(K_P P_{gen} - P_{tnd})$$

$$\dot{x}_{10} : \frac{d}{dt}(\alpha_F) = 0$$

wobei die Parameter

$K_P$     : Leistungsverlust = 0 bis 1 (dimensionslos) und

$\tau_P$     : Zeitkonstante = 0,1 s bis 60 s sind.

In einer bevorzugten Ausführungsform werden alle 10 nichtlinearen Differentialgleichungen erster Ordnung simultan berücksichtigt, d.h. das Modell besteht aus diesen 10 Gleichungen:

$$\dot{x}_1 : \frac{d}{dt}(R_F) = v_{Me} \cdot tan(\alpha_F)$$

$$\dot{x}_2 : \frac{d}{dt}(R_C) = v_{Cr} \cdot tan(\varphi_C)$$

$$\dot{x}_3 : \frac{d}{dt}(h_F) = v_{Me} - v_F$$

$$\dot{x}_4 : \frac{d}{dt}(h_C) = v_C - v_{Cr}$$

$$\dot{x}_5 : \frac{d}{dt}(V_v) = \frac{\rho_S}{\rho_M}(\pi R_F^2 v_{Me} - \dot{V}_{mf}) - \frac{\rho_S}{\rho_M}\pi R_C^2 v_{Cr} - \frac{\rho_M - \rho_S}{\rho_M}\dot{V}_h$$

$$\dot{x}_6 : \frac{d}{dt}(v_{Me}) = p_F \dot{P}_{ind} \cdot (R_F)^{w_F} \cdot \left(f_0 - \frac{f_0}{f_1}h_F\right)$$
$$+ p_F P_{ind} \cdot w_F \dot{R}_F (R_F)^{w_F - 1} \cdot \left(f_0 - \frac{f_0}{f_1}h_F\right)$$
$$+ p_F P_{ind} \cdot (R_F)^{w_F} \cdot \left(-\frac{f_0}{f_1}\dot{h}_F\right)$$

$$\dot{x}_7 : \frac{d}{dt}(v_{Cr}) = -p_C \dot{P}_{ind} \cdot (R_C)^{w_C} \cdot \left(c_0 - \frac{c_0}{c_1}h_C\right)$$
$$- p_C P_{ind} \cdot w_C \dot{R}_C (R_C)^{w_C - 1} \cdot \left(c_0 - \frac{c_0}{c_1}h_C\right)$$
$$- p_C P_{ind} \cdot (R_C)^{w_C} \cdot \left(-\frac{c_0}{c_1}\dot{h}_C\right)$$

$$\dot{x}_8 : \frac{d}{dt}(\varphi_C) = a_V \cdot k_V \cdot \dot{V}_v + a_R \cdot k_R \cdot \dot{R}_C + a_h \cdot k_h \cdot \dot{h}_C$$

$$\dot{x}_9 : \frac{d}{dt}(P_{ind}) = \frac{1}{\tau_P}(K_P P_{gen} - P_{ind})$$

$$\dot{x}_{10} : \frac{d}{dt}(\alpha_F) = 0$$

wobei die Modellparameter und die anderen Parameter die oben genannte Bedeutung aufweisen. Das Modell wird über 24 Parameter bzw. Modellparameter eingestellt, um die Prädiktion für die jeweils eingesetzten Anlagenkomponenten (z.B. Generator, Induktor) zu ermöglichen.

Der Zonenschmelzprozess wird von einem Kamerasystem aufgenommen und über eine Bildverarbeitung werden anhand von Messgrößen die Systemzustandswerteermittelt.Mindestens einer der Ist-Werte der Systemzustände Kristallradius ($R_C$), Vorratsstabsradius ($R_F$), Kristallwinkel($\varphi_C$), obere Zonenhöhe ($h_F$), untere Zonenhöhe ($h_C$), (sichtbares) Schmelzvolumen ($V_V$), Winkel am Vorratsstab ($\alpha_F$) wird direkt gemessen und ggf. durch einen Zustandsbeobachter gefiltert.Vorzugsweise werden alle sieben gerade genannten Systemzustände direkt gemessen. Die Ist-Werte der Systemzustände Geschwindigkeit der Abschmelzfront ($v_{Me}$) und/oder Geschwindigkeit der Kristallisationsfront ($v_{Cr}$) werden mit einem Zustandsbeobachter anhand der direktgemessenen Systemzustandswerte indirekt gemessen.Zusätzlich kann der Ist-Wert des SystemzustandsInduktorleistung($P_{ind}$) mit einem Zustandsbeobachter aus den direkt gemessenen Systemzustandswerten ermittelt, d.h. indirekt gemessen werden.

Der Zustandsbeobachter (vorzugsweise ein Kalman-Filter) erhält von der Messwerterfassung und vom Leitsystem die aktuell vorliegenden Mess-und Stellgrößen und berechnet mittels eines mathematischen Modells die Systemzustände. Ein Zustandsbeobachter wird eingesetzt, da nicht alle für eine Prädiktion notwendigen Systemzustände gemessen werden können (s.o.). Ein weiteres Ergebnis der Zustandsbeobachtung ist das Herausfiltern von messbedingtem Rauschen und Störungen aus den Messwerten (Filterung).

Berechnung der Stellgrößen

Bei der modellprädiktiven Regelung wird ein iteratives Optimierungsverfahren zur Berechnung der Stellgrößen eingesetzt. Dabei wird das Gütemaß, die Abweichung zwischen den Soll-Werten und prädizierten (vorhergesagten) Systemzuständen unter Berücksichtigung von Nebenbedingungen wie Ober-und Untergrenzen der Systemzustände, Grenzen der Stellgrößen minimiert. Zusätzlich fließen Stellgrößenveränderungen als aufsummierter Wert in das Gütemaß mit ein. Die Minimierung des Gütefunktionals erfolgt entweder mit Gradientenverfahren (z.B. interiorpointoptimizer (IPOPT), sequentialquadraticprogramming (SQP)) oder mit Nichtgradientenverfahren (z.B. Nelder-Mead).

EP 2 890 834 B1

Reglervorgaben

Abhängig von der aktuellen Züchtungsphase erfolgt die Festlegung der Soll-Werte sowie die der Stellgrößen- und Systemzustandsbeschränkungen. Zur Anpassung des Modellverhaltens an die Züchtungsphasen können die verwendeten Modellparameter variiert werden.

Prädiktion der Systemzustände

Der zukünftige Verlauf der Systemzustände wird durch numerische Integration der Modellgleichungen über ein festgelegtes Zeitintervall $H_x$ im Bereich von 30s bis 5 min berechnet. Dabei wird das Differentialgleichungssystem mit den vom Zustandsbeobachter bereitgestellten aktuellen Systemzuständen als Anfangswerten gelöst.

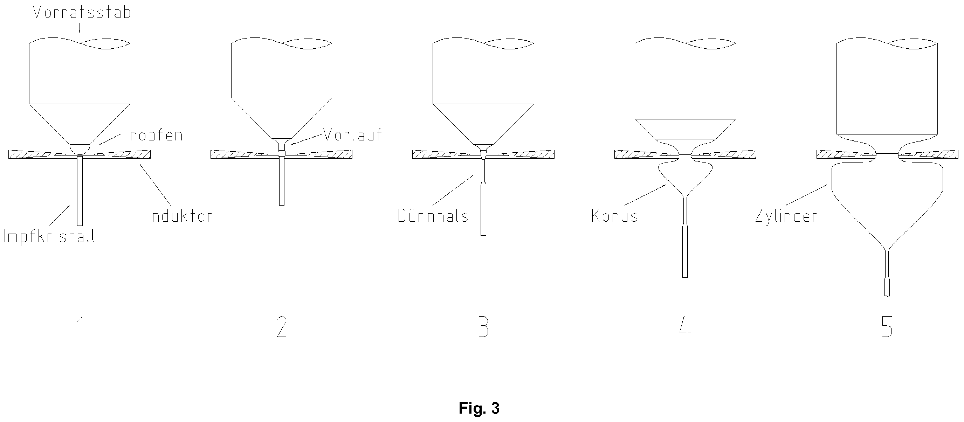

Generell werden beim Kristallisieren eines großen versetzungsfreien Einkristalls nach dem Zonenschmelzverfahren mehrere Stadien, im folgenden (Wachstums-)Schritte genannt, durchlaufen, die schematisch in Fig. 3 gezeigt sind: 1) Vorbereitungsphase → 2) Vorlaufphase → 3) Dünnhalsphase → 4) Konusphase→ 5) Zylinderphase→ Abzugsphase, wobei die für die Regelung interessanten Basisschritte die Dünnhalsphase, die Konusphase und die Zylinderphase sind.

Vor dem ersten Wachstumsschritt wird der Rezipient mit einem üblichen Schutzgas gefüllt. Der vorgeheizte Vorratsstab wird am unteren Ende induktiv angeschmolzen, bis ein Tropfen aus flüssigem Material in der Induktoröffnung hängt 1). Die Größe des Tropfens wird dabei so gewählt, das der als nächstes eingetauchte Impfkristall (typischerweise ein Stab mit geringerem Durchmesser als der Vorratsstab, beispielsweise 5 mm) beim Eintauchen anschmilzt. Danach wird der Vorlauf 2) geformt, in dem der Vorratsstab und der Impfkristall langsam nach oben gefahren werden. Dabei wird durch Leistungsrücknahme der Durchmesser des Vorratsstabes reduziert, bis er etwas größer als der Durchmesser des Impfkristalls ist und der Schmelztropfen die richtige Größe (Zonenhöhe etwa 6-7 mm) für das Wachsen des Dünnhalses hat.

In der Dünnhalsphase 3) wird durch schnelles abwärts ziehen des Impfkristalls und langsameres Vorschieben des Vorratsstabes der Durchmesser des Impfkristalls reduziert, beispielsweise auf 3 mm. Abhängig von der Kristallorientierung können damit die Versetzungen, die durch die thermischen Belastungen des Materials entstehen, aus dem Kristall heraus gleiten und nach einer Ziehlänge von typischer Weise mehr als 50 mm ist der Formkörper versetzungsfrei.

In der nachfolgenden Konusphase 4) wird der Kristalldurchmesser vergrößert durch Angleichen der Heizleistung und der Vorratsstab(hub)geschwindigkeit, wobei die Kristall(hub)-geschwindigkeit in der Konusphase konstant gehalten wird. Der Konus wird vergrößert bis der gewünschte Kristalldurchmesser erreicht ist.

Regelung des Dünnhalses

Bei der Regelung des Dünnhalses ist neben der geometrischen Form auch die Ziehgeschwindigkeit ein entschiedener Faktor zum Wachsen eines versetzungsfreien Kristalls. Für einen <100> Silizium-Kristall sollte die Ziehgeschwindigkeit in der Größenordnung von 5 bis 20 mm/min, vorzugsweise 7 bis 13 mm/min, beispielsweise 10 mm/min liegen, damit er gelingt. Es wird experimentell beobachtet, dass sich die flüssige Zone während des Wachsens des Dünnhalses langsam nach oben bewegt (bezogen auf den Induktor). Wenn die untere Zonenhöhe zu klein wird, d.h. die Kristallisationslinie zu dicht an der Induktorunterkante ist, kann die Gesamtzonenhöhe nicht mehr gehalten werden, da die Ankopplung des Induktors an die Schmelze zu schlecht wird. Demnach muss durch eine zusätzliche Nebenbedingung im Gütefunktional dafür gesorgt werden, dass die unteren Zonenhöhe einen kritischen Wert von 0 bis 10 mm (typischerweise 2 mm) nicht unterschreitet. Zu große Werte führen zum Auslaufen der Schmelze bzw. Abschnüren des Kristalls. Diese kritische Phase entsteht etwa auf der Hälfte des Dünnhalses.

Dabei unterscheiden wir zwei Varianten zur Stabilisierung der kritischen Phase während des Dünnhalses:

Variante 1 (konstante obere Hubgeschwindigkeit):

Bei dieser Variante wird mittels einer Vorsteuerung die untere Hubgeschwindigkeit aus dem stationären Stauchverhältnis

$$\frac{R_{F,sta}^2}{R_{C,sta}^2} = \frac{v_C}{v_F}$$

und dem Soll-Wert des Kristalldurchmessers eingestellt, sowie die Gesamtzonenhöhe modellbasiert geregelt. Um den Kristalldurchmesser möglichst schnell zu reduzieren sowie dem Auseinanderziehen der Zone beim Einschalten des Reglers entgegenzuwirken, ist es für das Einschalten notwendig, die aktuelle Gesamtzonenhöhe für den Anfang kleiner zu halten (um 0,1 bis 2 mm kleiner) und danach langsam in mehrerem Stufen oder über eine Rampe zu vergrößern. Ebenso war ein Untersteuern durch die Vorgabe eines kleineren Kristalldurchmessers (um 0,5 - 1,5 mm kleiner) hilfreich, um schneller den gewünschten Durchmesser zu erreichen. Zum Verhindern der kritischen Phase war es notwendig, eine untere Grenze von 0,1 bis 2 mm (typischerweise 1 mm) für die untere Zonenhöhe festzulegen, ist diese erreicht, wird die Leistung zügig erhöht, um den Prozess wieder zu stabilisieren.

Variante 2 (konstante untere Hubgeschwindigkeit):

Eine weitere Methode zum Unterdrücken der kritischen Phase im Dünnhals ist die Benutzung des Schmelzvolumens als modellbasierte Soll-Vorgabe für die Regelung unter Verwendung der konstanten unteren Hubgeschwindigkeit. Dabei wird angenommen, dass die flüssige Zone eine Trapezform bzw. Kegelstumpfform hat, dann kann man aus dem gemessenen Durchmesser des Vorratsstabes, dem Soll-Durchmesser des Formkörpers und der Gesamtzonenhöhe bzw. des Winkels des Trapezes $\varphi_T$ die Gesamtzonenhöhe und die Schmelzvolumenvorgabe

$$h_G = \frac{R_F - R_C}{tan(\varphi_T)}$$

$$V_v = \frac{\pi}{3} \cdot h_G \cdot (R_C^2 + R_C R_F + R_F^2)$$

für den modellbasierten Regler berechnen. Die Vorgaben liegen im Bereich von 4 bis 20 mm für $h_G$ und von 40 bis 600 mm$^3$ für $V_v$.

Die Gesamtzonenhöhe wurde dabei entweder in mehreren Stufen oder durch eine Rampe erhöht. Als Winkelvorgabe für $\varphi_T$ hat sich ein Wert von 10 bis 25°, beispielsweise etwa 13° für eine stabile Prozessführung bewährt.

Regelung der Konusphase

In der Konusphase 4) wird grob gesagt der Durchmesser bis zum Soll-Durchmesser des nutzbaren Formkörpers erhöht, dabei bleibt die unter Hubgeschwindigkeit (0,5 bis 15 mm/min, typischerweise 3 mm/min) konstant, um den Formkörper möglichst störungsfrei zu kristallisieren. Um eine stabile Prozessführung zu ermöglichen, ist es ebenso notwendig, die flüssige Schmelzzone aufzubauen ohne die beiden Grenzen, zum Einen das Zusammenfrieren von Formkörper und Vorratsstab und zum Anderen das Auslaufen der Schmelze bei Erreichen der Grenze der Kapillarstabilität, zu überschreiten. Prozessbegünstigend wird der Vorratsstab üblicherweise mit einem Konus (typischerweise 30°) benutzt.

Um diese Vorgaben zu erfüllen stehen folgende Varianten zur Verfügung:

Variante 1 (Gesamtzonenhöhe)

Bei dieser Variante wird mittels einer Vorsteuerung die obere Hubgeschwindigkeit aus dem stationären Stauchverhältnis und dem Soll-Wert des Kristalldurchmessers eingestellt, sowie die Gesamtzonenhöhe modelbasiert geregelt. Hierdurch können durch die Einhaltung von konstanten Abständen der Abschmelzfront und Kristallisationsfront zum Induktor Kristallisationsbedienungen erzeugt werden, die zu einer thermisch definierten Zylinderphase führen. Dies ermöglicht eine aussagekräftigere Validierung von realen Experimenten und numerischen Simulationen.

Variante 2 (Kristallwinkel)

Bei dieser Variante wird mittels einer Vorsteuerung die obere Hubgeschwindigkeit aus dem stationären Stauchverhältnis und der Soll-Wert des Kristalldurchmessers eingestellt, sowie der Kristallwinkel modelbasiert geregelt. Hierdurch kann direkt das Auslaufen der Schmelze aufgrund von zu starken Konuswinkeländerungen verhindert und direkt der Materialverlust durch den Kristallkonus beeinflusst werden, welches aus industrieller Sicht ein entscheidender Kostenfaktor ist. Des Weiteren, beeinflusst der Kristallwinkel die thermo-mechanischen Spannungen im Kristall und erlaubt somit die Verbesserung der Materialausbeute.

Regelung der Zylinderphase 5)

Die Zylinderphase 5) ist durch die Selbststabilität am einfachsten zu regeln. In dieser Phase sollen die auftretenden Durchmesserschwankungen reduziert werden, welche durch verschiedene Störungen verursacht werden, z. B. Durchmesserschwankungen / unsymmetrien des Vorratsstabes, ungleichmäßiges Abschmelzen des Vorratsstabes bedingt durch die Kornstruktur oder die Veränderungen der thermischen Bedingungen durch die wachsende Länge des Formkörpers zusammen mit der Längenreduktion des Vorratsstabes. Eine Kombination des Kristalldurchmessers und der Gesamtzonenhöhe als Soll-Werte erreichen eine Stabilisierung des Kristalldurchmessers durch die modellbasierte Regelung auf ±0,5 mm.

Zum Beenden des Züchtungsverfahrens wird der Durchmesser langsam reduziert, dabei besteht die Notwendigkeit zur Reduzierung des Schmelzvolumens, damit der Formkörper vom Vorratsstab getrennt wird ohne die Kapillarstabilität zu verletzen.

Die Erfindung wird im Folgenden anhand von Zeichnungen erläutert. Es zeigt:

Fig. 1     eine graphische Darstellung des Zonenschmelzverfahrens in der Konusphase,
Fig. 2     eine schematische Übersicht des Zonenschmelzverfahrens in der Konusphase,
Fig. 3     eine schematische Übersicht der einzelnen Phasen des Zonenschmelzverfahrens,
Fig. 4     eine schematische Darstellung der Prozessautomatisierung,
Fig. 5     eine schematische Darstellung des Regleraufbaus,
Fig. 6     eine Simulationsstudie für die Dünnhalsphase und
Fig. 7     eine Simulationsstudie für die Zylinderphase (voller Durchmesser).

Fig. 1 und 2 zeigen eine graphische Darstellung bzw. eine schematische Übersicht des Zonenschmelzverfahrens in der Konusphase mit den Stellgrößen Generatorleistung ($P_{Gen}$), Vorratsstabgeschwindigkeit ($v_F$) und Kristallgeschwindigkeit ($v_C$) und den Systemzustandswerten Vorratsstabsradius ($R_F$), Kristallradius ($R_C$), obere Zonenhöhe ($h_F$), untere Zonenhöhe ($h_C$), (sichtbares) Schmelzvolumen ($V_V$), Geschwindigkeit der Abschmelzfront ($v_{Me}$), Geschwindigkeit der Kristallisationsfront ($v_{Cr}$), Kristallwinkel ($\varphi_C$), Induktorleistung ($P_{ind}$), Winkel am Vorratsstab ($\alpha_F$). Gemessen werden hiervon $R_C$, $R_F$, $\varphi_C$, $h_F$, $h_C$, $V_v$ und $\alpha_F$. Die Geschwindigkeiten $v_{Me}$ und $v_{Cr}$, sowie $P_{ind}$ werden mittels Zustandsbeobachter indirekt gemessen. Zusätzlich gezeigte Kennwerte sind Gesamtzonenhöhe ($h_G$), Vorratsstablänge ($L_F$), Abstand des Vorratsstabshalters zur Induktoroberkante ($H_F$), Kristalllänge ($L_C$) und der Abstand des Kristallhalters zum Induktorunterkante ($H_C$).

Der feste Vorratsstab und der wachsende Kristall werden durch entsprechende Halter gehalten. Die Position des Induktors ist fest und die Geschwindigkeiten des Vorratsstabhalters $v_F$ und des Kristallhalters $v_C$ sind durch den Operator einstellbar/anpassbar. Das Schmelzvolumen V, welches durch die Generatorleistung $P_{Gen}$ erzielt wird, besteht zwischen Vorratsstab und Kristall. Die Schmelzlinie ist eine horizontale Linie, die den festen Vorratsstab von der offenen Abschmelzfront trennt. Unterhalb der Schmelzlinie fließt ein dünner Schmelzfilm entlang der offenen Abschmelzfront in die Schmelze. Der Winkel des Vorratsstabs direkt über der Schmelzlinie ist der Schmelzwinkel $\alpha_F$. Die obere Zonenhöhe $h_F$ ist der Abstand zwischen dem Induktoroberkante und der Schmelzlinie. Die untere Zonenhöhe $h_C$ ist definiert als der Abstand zwischen der Induktorunterkante und der Kristallisationslinie. Der Abstand zwischen der Schmelz- und Kristallisationslinie ist die gesamte Zonenhöhe $h_G$. Die Schmelzlinie bewegt sich mit der Schmelzgeschwindigkeit $v_{Me}$ und die Kristallisationslinie bewegt sich mit der Kristallisationsgeschwindigkeit $v_{Cr}$. Die sichtbare Form der Schmelze wird als freie Schmelzoberfläche bezeichnet. Das gesamte Schmelzvolumen V setzt sich zusammen aus dem sichtbaren Schmelzvolumen $V_v$ und dem nicht-sichtbaren, d.h. von der Kristalloberfläche verdeckten Schmelzvolumen $V_h$. Der Winkel auf Höhe der Kristallisationslinie ist der aktuelle Kristallwinkel $\varphi_C$.

Fig. 3 zeigt die typischen Phasen, die beim Zonenschmelzverfahren durchlaufen werden:

1) Tropfenbildung am Vorratsstab (Anschmelzen) mit anschließendem Eintauchen des Impfkristalls (Ankeimen) zum Starten des FZ Prozesses (Vorbereitungsphase).
2) Zurückschmelzen des Impfkristalls und aufwachsen von Material am Vorratsstab (Vorlauf) für die Vorbereitung der Dünnhalsphase (Vorlaufphase).
3) Start des Kristallwachstums durch Reduzierung des Kristalldurchmessers zum Erzeugen eines versetzungsfreien Einkristalls (Dünnhalsphase)
4) Vergrößerung des Durchmessers (Konusphase) mit kontinuierlichen Einschwenken auf den gewünschten Zieldurchmesser
5) Halten des Zieldurchmessers zum Wachsen des Nutzkristalls (Zylinderphase) mit anschließendem Beenden des Prozesses durch Reduktion des Durchmessers (Abzugsphase)

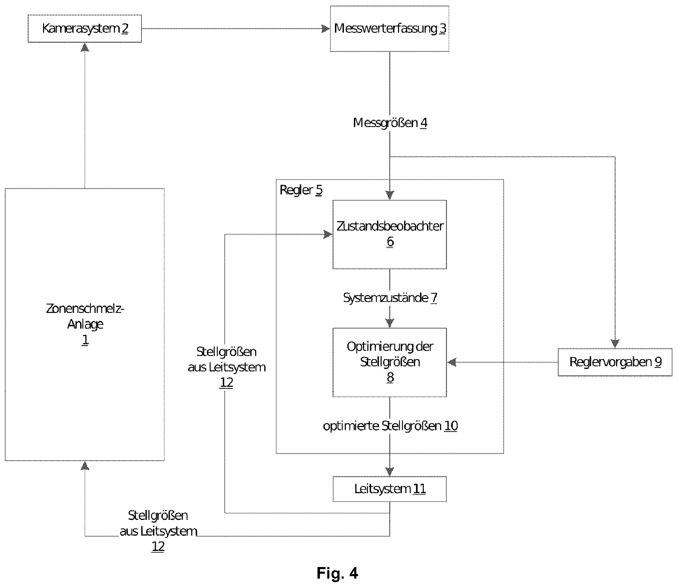

Fig. 4 zeigt den schematischen Aufbau der Prozessautomatisierung. Die Zonenschmelzanlage 1 wird mit einem Kamerasystem 2 überwacht und über eine Bildverarbeitung/Messwerterfassung 3 werden die Messgrößen 4 gemessen. Diese werden an den Regler 5 übergeben, wobei der Zustandsbeobachter 6 die Systemzustände 7 indirekt misst bzw. die direkt gemessenen Systemzustände filtert. Diese Systemzustände 7 werden in einem Optimierungsschritt 8 zur Optimierung der Stellgrößen verwandt, wobei die Messgrößen aus der Messwerterfassung 3 auch gegen die Reglervorgaben 9 abgeglichen werden und dies ebenfalls in den Optimierungsschritt 8 einfließt. Die optimierten Stellgrößen 10 werden an das Leitsystem 11 übergeben, welches diese Stellgrößen erneut an den Zustandsbeobachter 6 übergibt und der Optimierungsschritt 8 und die Weitergabe an das Leitsystem 10 mehrfach (2-20 mal, vorzugsweise 5-10 mal, z.B. 7 mal) wiederholt wird, bevor die Stellgrößen aus dem Leitsystem 12 wieder an die Zonenschmelzanlage 1 übergeben werden.

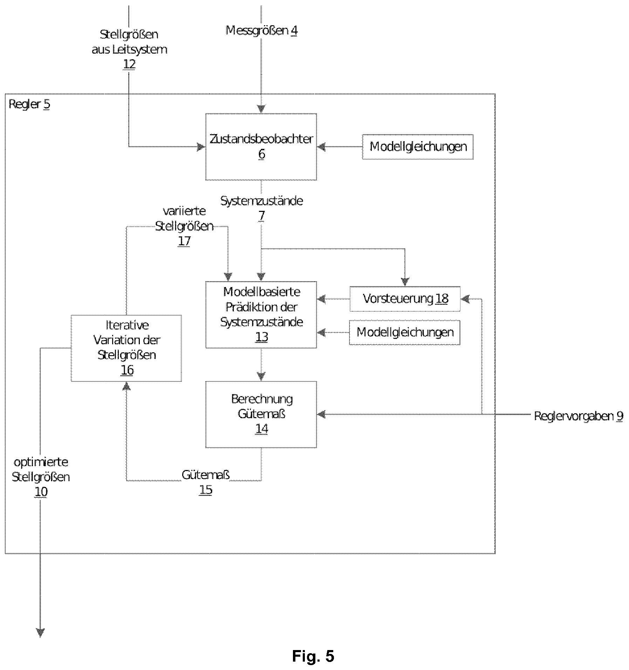

Fig.5 zeigt den schematischen Aufbau des Reglers 5 im Detail. Die Stellgrößen 12 und die Messgrößen 4 erreichen den Zustandsbeobachter 6, welcher aus dem Modell die Systemzustände ermittelt und dazu die Modellgleichungen löst. Die gefilterten Systemzustände werden von dermodellbasierten Prädiktion benutzt, um die prädizierten Systemzustände 13 zu berechnen. Daraus werden zusammen mit den Reglervorgaben 9 in derGütemaß-Berechnung 14 dasGütemaß 15 ermittelt. Zur Berechnung der optimalen Stellgrößen 10 wird durch die iterative Variation 16 der Stellgrößen das Gütemaß 15 berechnet, in demdie variierte Stellgrößen 17 in dermodellbasierte Prädiktion der Systemzustände 13 berücksichtigt werden. Nach mehrmaligem Durchlauf(2-20 mal, vorzugsweise 5-10 mal, z.B. 7 mal) erhält man die optimiertenStellgrößen 10 mit einem minimierten Gütemaß, die an das Leitsystem 11 (nicht gezeigt) weitergegeben werden. Methoden zur Minimierung des Gütefunktionals sind zum einen Gradientenverfahren(z.B. interiorpointoptimizer (IPOPT), sequentialquadraticprogramming (SQP)) und zum anderen Nichtgradientenverfahren (z.B. Nelder-Mead). Es ist möglich, eine Vorsteuerung 18 zur Berechnung einer oder mehrerer Stellgrößen innerhalb der modellprädiktiven Regelung einzusetzen.

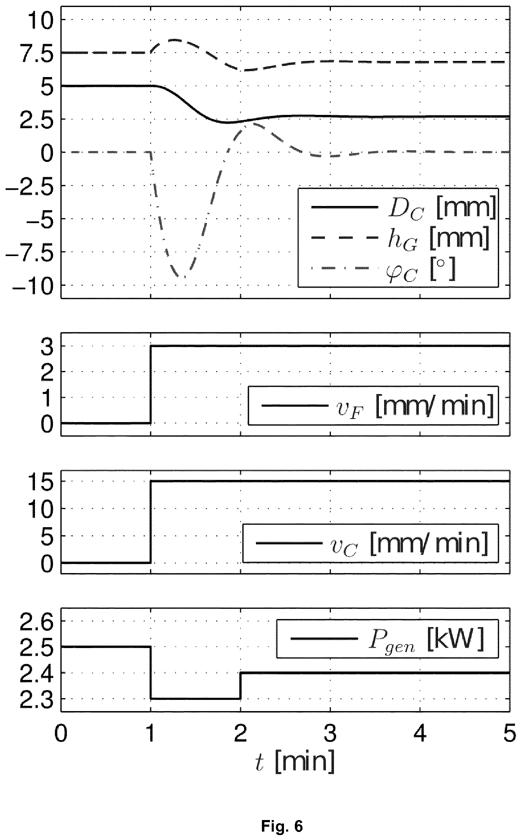

Fig. 6 zeigt eine Simulationsstudie für die Dünnhals-Phase, wobei die eingestellten Werte der Simulation wie folgt sind:

$R_F$ = 3 mm ($D_F$ = 6 mm), $R_C$ = 2,5 mm ($D_C$ = 5 mm), $h_F$ = 4 mm, $h_C$ = 3,5 mm, $V$ = 0,2 $cm^3$, $\alpha_F$ = $\varphi_C$ = 0° und $v_{Me}$= $v_{Cr}$= 0 mm/min; Modellparameter: $K_P$ = 1, $\tau_P$= 2 s, $a_{mf}$ = 0, $a_V$= 0,08, $a_R$= 0,09, $a_h$ = 0,08, $f_0$ = 0,2 mm, $f_1$ = 6,0 $mm$, $c_0$ = 0,2 mm, $c_1$ = 8,0 $mm$,$p_F$=$p_C$=0,8 (kWs)$^{-1}$ und $w_F$=$w_C$=1.

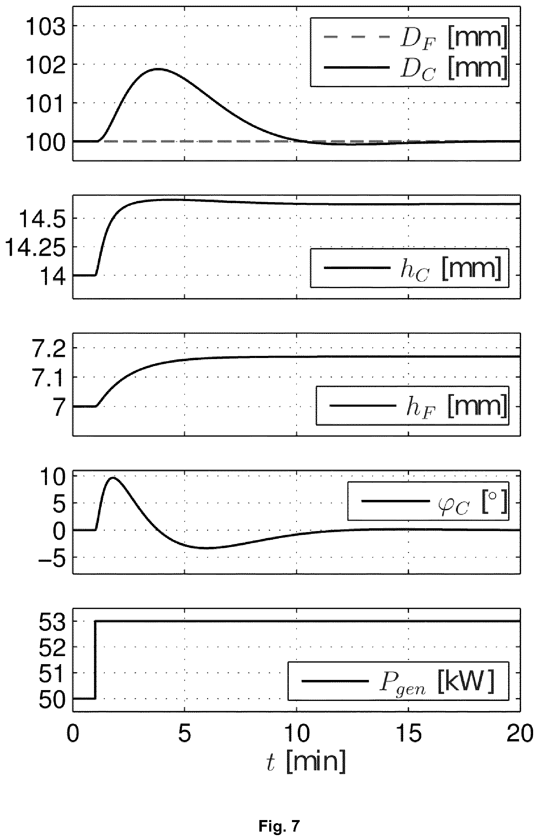

Fig. 7 zeigt eine Simulationsstudie für die Zylinderphase, wobei die eingestellten Werte der Simulation wie folgt sind:

$R_F$=50 mm ($D_F$= 100 mm), $R_C$=50 mm ($D_C$ = 100 mm), $h_F$=7 mm, $h_C$=14 mm, $V$ = 65 $cm^3$, $\alpha_F$=$\varphi_C$=0° und $v_{Me}$=$v_{Cr}$=3,8 mm/min; Modellparameter: $R_N$ = 10 mm, $K_P$ = 1, $\tau_P$= 5 s, $a_{mf}$ = 1,5,$a_V$= 1,4, $a_R$= 1,9, $a_h$ = 1,3, $f_0$ = 1 mm, $f_1$ = 10 $mm$, $c_0$ = 8 mm, $c_1$ = 25 $mm$,$p_F$=$p_C$=0,001 (kWs)$^{-1}$ und $w_F$=$w_C$=0,2.

## Bezugszeichenliste

1     Zonenschmelzanlage
2     Kamerasystem
3     Bildverarbeitung/Messwerterfassung
4     Messgrößen
5     Regler
6     Zustandsbeobachter
7     Systemzustände
8     Optimierungsschritt
9     Reglervorgaben
10     optimierte Stellgrößen
11     Leitsystem
12     Stellgrößen aus dem Leitsystem
13     Modellbasierte Prädiktion der Systemzustände
14     Berechnung Gütemaß
15     Gütemaß
16     iterative Variation der Stellgrößen
17     variierte Stellgrößen
18     Vorsteuerung

## Patentansprüche

1. Verfahren zur geregelten Erzeugung von kristallinen Formkörpern im Zonenschmelzverfahren durch Beeinflussung von Stellgrößen, wobei die Art der Beeinflussung anhand eines Abgleichs von gemessenen Ist-Werten mit Soll- und prädizierten Verlaufs-Werten von Systemzuständen ermittelt wird, wobei die Ist-Werte der Systemzustände direkt gemessen und/oder indirekt mittels eines Zustandsbeobachters gemessen werden, **dadurch gekennzeichnet, dass** die prädizierten Verlaufs-Werte, ausgehend von den direkt oder indirekt gemessenen Ist-Werten, modellbasiert berechnet werden, wobei das zugrunde liegende Modell die folgenden Gleichungen umfasst:

$$\dot{x}_1 : \frac{d}{dt}(R_F) = v_{Me} \cdot tan(\alpha_F)$$

$$\dot{x}_2 : \frac{d}{dt}(R_C) = v_{Cr} \cdot tan(\varphi_C)$$

$$\dot{x}_3 : \frac{d}{dt}(h_F) = v_{Me} - v_F$$

$$\dot{x}_4 : \frac{d}{dt}(h_C) = v_C - v_{Cr}$$

mit Vorratsstabsradius ($R_F$), Kristallradius ($R_C$), obere Zonenhöhe ($h_F$), untere Zonenhöhe ($h_C$), Geschwindigkeit der Abschmelzfront ($v_{Me}$), Geschwindigkeit der Kristallisationsfront ($v_{Cr}$), Kristallwinkel ($\varphi_C$), Induktorleistung ($P_{ind}$) und Winkel am Vorratsstab ($\alpha_F$) und dass mindestens eine Stellgröße, ausgewählt aus Generatorleistung ($P_{Gen}$), Vorratsstabgeschwindigkeit ($v_F$) und Kristallgeschwindigkeit ($v_C$), so verändert wird, dass die Abweichung von den Soll- und den prädizierten Verlaufs-Werten verringert wird.

2. Verfahren zur geregelten Erzeugung von kristallinen Formkörpern im Zonenschmelzverfahren durch Beeinflussung von Stellgrößen nach Anspruch 1, **dadurch gekennzeichnet, dass** mindestens ein Soll- und prädizierter Verlaufs-Wert der Systemzustände ein Wertebereich ist, wobei mindestens eine Anforderung an einer unteren- oder oberen Grenzen des Systemzustandswertebereichs berücksichtigt wird.

3. Verfahren zur geregelten Erzeugung von kristallinen Formkörpern im Zonenschmelzverfahren durch Beeinflussung von Stellgrößen nach Anspruch 1, **dadurch gekennzeichnet, dass** mindestens eine Stellgröße einen Wertebereich umfasst, wobei mindestens eine Anforderung an einer unteren- oder oberen Grenze des Stellgrößenwertebereichs berücksichtigt wird.

4. Verfahren zur geregelten Erzeugung von kristallinen Formkörpern im Zonenschmelzverfahren durch Beeinflussung von Stellgrößen nach Anspruch 1 oder 2, **dadurch gekennzeichnet, dass** mindestens ein Soll-Wert oder -bereich von $\pm$ 10 % um den Soll- Wert eines Systemzustands, ausgewählt aus Vorratsstabsradius ($R_F$), Kristallradius ($R_C$), obere Zonenhöhe ($h_F$), untere Zonenhöhe ($h_C$), (sichtbares) Schmelzvolumen ($V_V$), Geschwindigkeit der Abschmelzfront ($v_{Me}$), Geschwindigkeit der Kristallisationsfront ($v_{Cr}$), Kristallwinkel ($\varphi_C$), Induktorleistung ($P_{ind}$) und Winkel am Vorratsstab ($\alpha_F$) modellbasiert ermittelt wird.

5. Verfahren zur geregelten Erzeugung von kristallinen Formkörpern im Zonenschmelzverfahren durch Beeinflussung von Stellgrößen nach einem oder mehreren der Ansprüche 1-4, **dadurch gekennzeichnet, dass** das zugrunde liegende Modell weiterhin die folgende Gleichung umfasst:

$$\dot{x}_5 : \frac{d}{dt}(V_v) = \frac{\rho_S}{\rho_M}(\pi R_F^2 v_{Me} - \dot{V}_{mf}) - \frac{\rho_S}{\rho_M}\pi R_C^2 v_{Cr} - \frac{\rho_M - \rho_S}{\rho_M}\dot{V}_h$$

mit

$$\dot{V}_{mf} = a_{mf}\frac{\pi}{3}\left(\dot{h}_F(R_F^2 + R_F R_N + R_N^2) + h_F(2R_F + R_N)\dot{R}_F\right)$$

$$\dot{V}_h = \dot{R}_C\left(a_1 + 2a_2(R_C - a_0) + 3a_3(R_C - a_0)^2\right) \text{ für } R_c > a_0 \text{ sonst } 0$$

wobei die Parameter

$\rho_M$ : Dichte geschmolzenes Material [$\rho Si_M$ = 2530 kg/m$^3$]
$\rho_s$ : Dichte des festen Materials [$\rho SiS$ = 2340 kg/m3]
$a_{mf}$ : Skalierungsfaktor im Bereich von 0 bis 3
$R_N$ : Radius des Schmelzhalses von 1 bis 40 mm
$a_0$ : statischer Kennlinienfaktor von 8 bis 20 mm
$a_1$ : statischer Kennlinienfaktor von 400 bis 700 mm$^2$
$a_2$ : statischer Kennlinienfaktor von -50 bis -10 mm
$a_3$ : statischer Kennlinienfaktor von 1 bis 4 sind.

6. Verfahren zur geregelten Erzeugung von kristallinen Formkörpern im Zonenschmelzverfahren durch Beeinflussung von Stellgrößen nach einem oder mehreren der Ansprüche 4-5, **dadurch gekennzeichnet, dass** das zugrunde liegende Modell weiterhin die folgende Gleichung umfasst:

$$\dot{x}_6 : \frac{d}{dt}(v_{Me}) = p_F \dot{P}_{ind} \cdot (R_F)^{w_F} \cdot \left(f_0 - \frac{f_0}{f_1}h_F\right)$$
$$+ p_F P_{ind} \cdot w_F \dot{R}_F (R_F)^{w_F - 1} \cdot \left(f_0 - \frac{f_0}{f_1}h_F\right)$$
$$+ p_F P_{ind} \cdot (R_F)^{w_F} \cdot \left(-\frac{f_0}{f_1}\dot{h}_F\right)$$

wobei die Parameter
$f_0$ (0,001 bis 30 mm), $f_1$ (0,001 bis 30 mm), $p_F$ (0,00001 bis 2 (kWs)$^{-1}$), $w_F$ (0 bis 2, dimensionslos) individuelle Modellparameter bedeuten.

7. Verfahren zur geregelten Erzeugung von kristallinen Formkörpern im Zonenschmelzverfahren durch Beeinflussung von Stellgrößen nach einem oder mehreren der Ansprüche 4-6, **dadurch gekennzeichnet, dass** das zugrunde liegende Modell weiterhin die folgende Gleichung umfasst:

$$\dot{x}_7 : \frac{d}{dt}(v_{Cr}) = -p_C \dot{P}_{ind} \cdot (R_C)^{w_C} \cdot \left(c_0 - \frac{c_0}{c_1}h_C\right)$$
$$- p_C P_{ind} \cdot w_C \dot{R}_C (R_C)^{w_C - 1} \cdot \left(c_0 - \frac{c_0}{c_1}h_C\right)$$
$$- p_C P_{ind} \cdot (R_C)^{w_C} \cdot \left(-\frac{c_0}{c_1}\dot{h}_C\right)$$

wobei die Parameter $c_0$ (0,001 bis 30 mm), $c_1$ (0,001 bis 30 mm), $p_C$ (0,00001 bis 2 (kWs)$^{-1}$), $w_C$ (0 bis 2, dimensionslos) individuelle Modellparameter bedeuten.

8. Verfahren zur geregelten Erzeugung von kristallinen Formkörpern im Zonenschmelzverfahren durch Beeinflussung von Stellgrößen nach einem oder mehreren der Ansprüche 4-7, **dadurch gekennzeichnet, dass** das zugrunde liegende Modell weiterhin die folgende Gleichung umfasst:

$$\dot{x}_8 : \frac{d}{dt}(\varphi_C) = a_V \cdot k_V \cdot \dot{V}_v + a_R \cdot k_R \cdot \dot{R}_C + a_h \cdot k_h \cdot \dot{h}_C$$

wobei die Parameter

$a_V$ : ein Winkelkorrekturfaktor = 0 bis 3
$a_R$ : ein Winkelkorrekturfaktor = 0 bis 3

$a_h$ : ein Winkelkorrekturfaktor = 0 bis 3

$k_V$ : ein vom Kristallradius $R_C$ abhängiger Faktor zwischen 3 und 0,0001°/mm³ bei $R_C$ zwischen 1 und 100 mm

$k_R$ : ein vom Kristallradius $R_C$ abhängiger Faktor zwischen -80 und -1°/mm bei $R_c$ zwischen 1 und 100 mm

$k_h$ : ein vom Kristallradius $R_C$ abhängiger Faktor zwischen -60 und -0,01°/mm bei $R_c$ zwischen 1 und 100 mm

sind.

**9.** Verfahren zur geregelten Erzeugung von kristallinen Formkörpern im Zonenschmelzverfahren durch Beeinflussung von Stellgrößen nach einem oder mehreren der Ansprüche 4-8, **dadurch gekennzeichnet, dass** das zugrunde liegende Modell weiterhin die folgenden Gleichungen umfasst:

$$\dot{x}_9 : \frac{d}{dt}(P_{ind}) = \frac{1}{\tau_P}(K_P P_{gen} - P_{ind})$$

$$\dot{x}_{10} : \frac{d}{dt}(\alpha_F) = 0$$

wobei die Parameter

$K_P$ : Leistungsübertragung = 0 bis 1 (dimensionslos) und

$\tau_P$ : Zeitkonstante = 0,1 s bis 60 s sind.

**10.** Verfahren zur geregelten Erzeugung von kristallinen Formkörpern im Zonenschmelzverfahren durch Beeinflussung von Stellgrößen nach einem oder mehreren der Ansprüche 1-9, **dadurch gekennzeichnet, dass** mindestens einer der Ist-Werte der Systemzustände Kristallradius ($R_C$), Vorratsstabsradius ($R_F$), Kristallwinkel($\varphi_C$), obere Zonenhöhe ($h_F$), untere Zonenhöhe ($h_C$), (sichtbares) Schmelzvolumen ($V_V$), Winkel am Vorratsstab ($\alpha_F$) gemessen und ggf. durch einen Zustandsbeobachter gefiltert wird.

**11.** Verfahren zur geregelten Erzeugung von kristallinen Formkörpern im Zonenschmelzverfahren durch Beeinflussung von Stellgrößen nach einem oder mehreren der Ansprüche 1-10, **dadurch gekennzeichnet, dass** die Ist-Werte der Systemzustände Geschwindigkeit der Abschmelzfront ($v_{Me}$) und/oder der Kristallisationsfront ($v_C$) indirekt mit einem Zustandsbeobachter aus den direkt gemessenen Systemzustandswerten gemessen werden.

**12.** Verfahren zur geregelten Erzeugung von kristallinen Formkörpern im Zonenschmelzverfahren durch Beeinflussung von Stellgrößen nach einem oder mehreren der Ansprüche 1-11, **dadurch gekennzeichnet, dass** der Ist-Wert des Systemzustands Induktorleistung ($P_{ind}$) indirekt mit einem Zustandsbeobachter aus gemessenen Systemzustandswerten gemessen wird.

**13.** Verfahren zur geregelten Erzeugung von kristallinen Formkörpern im Zonenschmelzverfahren durch Beeinflussung von Stellgrößen nach Anspruch 10 oder 12, **dadurch gekennzeichnet, dass** der Zustandsbeobachter ein Kalman-Filter ist.

**14.** Verfahren zur geregelten Erzeugung von kristallinen Formkörpern im Zonenschmelzverfahren durch Beeinflussung von Stellgrößen nach einem oder mehreren der Ansprüche 1-13, **dadurch gekennzeichnet, dass** als kristalliner Formkörper ein Silizium-Einkristall erzeugt wird.

**Claims**

**1.** Method for the controlled production of crystalline moulded bodies in the zone-melting process by influencing manipulated variables, the nature of the influencing being determined on the basis of a comparison of measured actual values with target values and predicted course values of system states, the actual values of the system states being measured directly and/or measured indirectly by means of a state observer, **characterized in that** the predicted course values are calculated in a model-based manner on the basis of the directly or indirectly measured actual values, the model that is taken as a basis comprising the following equations:

$$\dot{x}_1: \frac{d}{dt}(R_F) = v_{Me} \cdot tan(\alpha_F)$$

$$\dot{x}_2: \frac{d}{dt}(R_C) = v_{Cr} \cdot tan(\varphi_C)$$

$$\dot{x}_3: \frac{d}{dt}(h_F) = v_{Me} - v_F$$

$$\dot{x}_4: \frac{d}{dt}(h_C) = v_C - v_{Cr}$$

with the feed rod radius ($R_F$), crystal radius ($R_C$), upper zone height ($h_F$), lower zone height ($h_C$), speed of the melting front ($v_{Me}$), speed of the crystallization front ($v_{Cr}$), crystal angle ($\varphi_C$), inductor power ($P_{ind}$) and angle at the feed rod ($\alpha_F$), and **in that** at least one manipulated variable, selected from the generator power ($P_{Gen}$), feed rod speed ($v_F$) and crystal speed ($v_C$), is changed in such a way that the deviation from the target values and the predicted course values is reduced.

2. Method for the controlled production of crystalline moulded bodies in the zone-melting process by influencing manipulated variables according to Claim 1, **characterized in that** at least one target value and predicted course value of the system states is a range of values, at least one requirement being taken into account at a lower or upper limit of the range of values for the system state.

3. Method for the controlled production of crystalline moulded bodies in the zone-melting process by influencing manipulated variables according to Claim 1, **characterized in that** at least one manipulated variable comprises a range of values, at least one requirement being taken into account at a lower or upper limit of the range of values for the manipulated variables.

4. Method for the controlled production of crystalline moulded bodies in the zone-melting process by influencing manipulated variables according to Claim 1 or 2, **characterized in that** at least one target value or range of $\pm 10\%$ around the target value of a system state, selected from the feed rod radius ($R_F$), crystal radius ($R_C$), upper zone height ($h_F$), lower zone height ($h_C$), (visible) melt volume (Vv), speed of the melting front ($v_{Me}$), speed of the crystallization front ($v_{Cr}$), crystal angle ($\varphi_C$), inductor power ($P_{ind}$) and angle at the feed rod ($\alpha_F$), is determined in a model-based manner.

5. Method for the controlled production of crystalline moulded bodies in the zone-melting process by influencing manipulated variables according to one or more of Claims 1-4, **characterized in that** the model that is taken as a basis also comprises the following equation:

$$\dot{x}_5: \frac{d}{dt}(V_v) = \frac{\rho_S}{\rho_M}\left(\pi R_F^2 v_{Me} - \dot{V}_{mf}\right) - \frac{\rho_S}{\rho_M}\pi R_C^2 v_{Cr} - \frac{\rho_M - \rho_S}{\rho_M}\dot{V}_h$$

with

$$\dot{V}_{mf} = a_{mf}\frac{\pi}{3}\left(\dot{h}_F(R_F^2 + R_F R_N + R_N^2) + h_F(2R_F + R_N)\dot{R}_F\right)$$

$$\dot{V}_h = \dot{R}_C\left(a_1 + 2a_2(R_C - a_0) + 3a_3(R_C - a_0)^2\right)$$

for $R_c > \alpha_0$ otherwise 0,
where the parameters are

$\rho_M$ : density of the molten material [$\rho Si_M$ = 2530 kg/m³]
$\rho_s$ : density of the solid material [$\rho SiS$ = 2340 kg/m³]
$a_{mf}$ : scaling factor in the range from 0 to 3
$R_N$ : radius of the melt neck from 1 to 40 mm
$a_0$ : statistical characteristic factor from 8 to 20 mm
$a_1$ : statistical characteristic factor from 400 to 700 mm²
$a_2$ : statistical characteristic factor from -50 to -10 mm
$a_3$ : statistical characteristic factor from 1 to 4.

6. Method for the controlled production of crystalline moulded bodies in the zone-melting process by influencing manipulated variables according to one or more of Claims 4-5, **characterized in that** the model that is taken as a basis also comprises the following equation:

$$\dot{x}_6 : \frac{d}{dt}(v_{Me}) = p_F \dot{P}_{ind} \cdot (R_F)^{w_F} \cdot \left(f_0 - \frac{f_0}{f_1} h_F\right)$$
$$+ p_F P_{ind} \cdot w_F \dot{R}_F (R_F)^{w_F-1} \cdot \left(f_0 - \frac{f_0}{f_1} h_F\right)$$
$$+ p_F P_{ind} \cdot (R_F)^{w_F} \cdot \left(-\frac{f_0}{f_1} \dot{h}_F\right)$$

where the parameters
$f_0$ (0.001 to 30 mm), $f_1$ (0.001 to 30 mm), $p_F$ (0.00001 to 2 (kWs)$^{-1}$) and $w_F$ (0 to 2, dimensionless) signify individual model parameters.

7. Method for the controlled production of crystalline moulded bodies in the zone-melting process by influencing manipulated variables according to one or more of Claims 4-6, **characterized in that** the model that is taken as a basis also comprises the following equation:

$$\dot{x}_7 : \frac{d}{dt}(v_{Cr}) = -p_C \dot{P}_{ind} \cdot (R_C)^{w_C} \cdot \left(c_0 - \frac{c_0}{c_1} h_C\right)$$
$$- p_C P_{ind} \cdot w_C \dot{R}_C (R_C)^{w_C-1} \cdot \left(c_0 - \frac{c_0}{c_1} h_C\right)$$
$$- p_C P_{ind} \cdot (R_C)^{w_C} \cdot \left(-\frac{c_0}{c_1} \dot{h}_C\right)$$

where the parameters $c_0$ (0.001 to 30 mm), $c_1$ (0.001 to 30 mm), $p_C$ (0.00001 to 2 (kWs)$^{-1}$) and $w_C$ (0 to 2, dimensionless) signify individual model parameters.

8. Method for the controlled production of crystalline moulded bodies in the zone-melting process by influencing manipulated variables according to one or more of Claims 4-7, **characterized in that** the model that is taken as a basis also comprises the following equation:

$$\dot{x}_8 : \frac{d}{dt}(\varphi_C) = a_V \cdot k_V \cdot \dot{V}_v + a_R \cdot k_R \cdot \dot{R}_C + a_h \cdot k_h \cdot \dot{h}_C$$

where the parameters are

av : an angle correction factor = 0 to 3
$a_R$ : an angle correction factor = 0 to 3
$a_h$ : an angle correction factor = 0 to 3
$k_V$ : a factor dependent on the crystal radius $R_C$ of between 3 and 0.0001°/mm³ with $R_C$ between 1 and 100 mm
$k_R$ : a factor dependent on the crystal radius $R_C$ of between -80 and -1°/mm with $R_C$ between 1 and 100 mm
$k_h$ : a factor dependent on the crystal radius $R_C$ of between -60 and -0.01°/mm with $R_C$ between 1 and 100 mm.

9. Method for the controlled production of crystalline moulded bodies in the zone-melting process by influencing manipulated variables according to one or more of Claims 4-8, **characterized in that** the model that is taken as a basis also comprises the following equations:

$$\dot{x_9}: \frac{d}{dt}(P_{ind}) = \frac{1}{\tau_P}\left(K_P P_{gen} - P_{ind}\right)$$

$$\dot{x_{10}}: \frac{d}{dt}(\alpha_F) = 0$$

where the parameters are

$K_P$ : power transmission = 0 to 1 (dimensionless) and
$\tau_P$ : time constant = 0.1 s to 60 s.

10. Method for the controlled production of crystalline moulded bodies in the zone-melting process by influencing manipulated variables according to one or more of Claims 1-9, **characterized in that** at least one of the actual values of the system states, the crystal radius ($R_C$), feed rod radius ($R_F$), crystal angle ($\varphi_C$), upper zone height ($h_F$), lower zone height ($h_C$), (visible) melt volume ($V_V$) and angle at the feed rod ($\alpha_F$), is measured and if appropriate filtered through a state observer.

11. Method for the controlled production of crystalline moulded bodies in the zone-melting process by influencing manipulated variables according to one or more of Claims 1-10, **characterized in that** the actual values of the system states, the speed of the melting front ($v_{Me}$) and/or the crystallization front ($v_C$), are measured indirectly by a state observer from the directly measured system state values.

12. Method for the controlled production of crystalline moulded bodies in the zone-melting process by influencing manipulated variables according to one or more of Claims 1-11, **characterized in that** the actual value of the system state of the inductor power ($P_{ind}$) is measured indirectly by a state observer from measured system state values.

13. Method for the controlled production of crystalline moulded bodies in the zone-melting process by influencing manipulated variables according to Claim 10 or 12, **characterized in that** the state observer is a Kalman filter.

14. Method for the controlled production of crystalline moulded bodies in the zone-melting process by influencing manipulated variables according to one or more of Claims 1-13, **characterized in that** a silicon single crystal is produced as the crystalline moulded body.

**Revendications**

1. Procédé de production régulée de corps conformés cristallins dans le procédé de la zone fondue par influence de grandeurs de réglage, dans lequel le type d'influence est déterminé au moyen d'une comparaison des valeurs réelles mesurées avec les valeurs cible et les valeurs de déroulement prédites des états du système, dans lequel la valeur réelle de l'état du système est mesurée directement et/ou mesurée indirectement par le biais d'un observateur d'état, **caractérisé en ce que** les valeurs de déroulement prédites sont calculées selon un modèle à partir des valeurs réelles mesurées directement ou indirectement, dans lequel le modèle sous-jacent comprend les équations suivantes :

$$\dot{x_1}: \frac{d}{dt}(R_F) = v_{Me} \cdot tan(\alpha_F)$$

$$\dot{x_2}: \frac{d}{dt}(R_C) = v_{Cr} \cdot tan(\varphi_C)$$

$$\dot{x_3}: \frac{d}{dt}(h_F) = v_{Me} - v_F$$

$$\dot{x_4}: \frac{d}{dt}(h_C) = v_C - v_{Cr}$$

où ($R_F$) est le rayon du barreau d'alimentation, ($R_C$) le rayon du cristal, ($h_F$) la hauteur de la zone supérieure, ($h_C$) la hauteur de la zone inférieure, ($v_{Me}$) la vitesse du front de fusion, ($v_{Cr}$) la vitesse du front de cristallisation, ($\varphi_C$) l'angle du cristal, ($P_{ind}$) la puissance d'induction et ($\alpha_F$) l'angle du barreau d'alimentation, et **en ce qu'**au moins une grandeur de réglage, choisie parmi la puissance du générateur ($P_{Gen}$), la vitesse du barreau d'alimentation ($v_F$) et la vitesse du cristal ($v_C$) est modifiée de façon à réduire la déviation par rapport aux valeurs cible et aux valeurs de déroulement prédites.

2. Procédé de production régulée de corps conformés cristallins dans le procédé de la zone fondue par influence de grandeurs de réglage selon la revendication 1, **caractérisé en ce qu'**au moins une valeur cible et une valeur de déroulement prédite des états du système sont des intervalles de valeurs, dans lequel au moins une condition pour une borne supérieure ou inférieure de l'intervalle de valeurs de l'état du système est prise en compte.

3. Procédé de production régulée de corps conformés cristallins dans le procédé de la zone fondue par influence de grandeurs de réglage selon la revendication 1, **caractérisé en ce qu'**au moins une grandeur de réglage comprend un intervalle de valeurs, dans lequel au moins une condition pour une borne supérieure ou inférieure de l'intervalle de valeurs de la grandeur de réglage est prise en compte.

4. Procédé de production régulée de corps conformés cristallins dans le procédé de la zone fondue par influence de grandeurs de réglage selon la revendication 1 ou 2, **caractérisé en ce qu'**au moins une valeur cible, ou un intervalle de $\pm 10$ % autour de la valeur cible, d'un état du système, choisie parmi le rayon du barreau d'alimentation ($R_F$), le rayon du cristal ($R_C$), la hauteur de la zone supérieure ($h_F$), la hauteur de la zone inférieure ($h_C$), le volume (visible) de fusion ($V_v$), la vitesse du front de fusion ($v_{Me}$), la vitesse du front de cristallisation ($v_{Cr}$), l'angle du cristal ($\varphi_C$), la puissance d'induction ($P_{ind}$) et l'angle du barreau d'alimentation ($\alpha_F$), est déterminée selon un modèle.

5. Procédé de production régulée de corps conformés cristallins dans le procédé de la zone fondue par influence de grandeurs de réglage selon une ou plusieurs des revendications 1 à 4, **caractérisé en ce que** le modèle sous-jacent comprend de plus l'équation suivante :

$$\dot{x_5}: \frac{d}{dt}(V_v) = \frac{\rho_S}{\rho_M}\left(\pi R_F^2 v_{Me} - \dot{V}_{mf}\right) - \frac{\rho_S}{\rho_M}\pi R_C^2 v_{Cr} - \frac{\rho_M - \rho_S}{\rho_M}\dot{V}_h$$

où

$$\dot{V}_{mf} = a_{mf}\frac{\pi}{3}\left(\dot{h}_F(R_F^2 + R_F R_N + R_N^2) + h_F(2R_F + R_N)\dot{R}_F\right)$$

$$\dot{V}_h = \dot{R}_C(a_1 + 2a_2(R_C - a_0) + 3a_3(R_C - a_0)^2)\ pour\ R_C > a_0\ sinon\ 0$$

dans lequel les paramètres sont

$\rho_M$ : densité du matériau fondu [$\rho Si_M$ = 2530 $kg/m^3$]
$\rho_S$ : densité du matériau solidifié [$\rho SiS$ = 2340 $kg/m^3$]
$a_{mf}$ : facteur d'échelle dans un intervalle compris entre 0 et 3
$R_N$ : rayon du col de fusion compris entre 1 et 40 mm
$a_0$ : facteur statique de courbe caractéristique compris entre 8 et 20 mm
$a_1$ : facteur statique de courbe caractéristique compris entre 400 et 700 $mm^2$
$a_2$ : facteur statique de courbe caractéristique compris entre -50 et -10 mm

$a_3$ : facteur statique de courbe caractéristique compris entre 1 et 4.

6. Procédé de production régulée de corps conformés cristallins dans le procédé de la zone fondue par influence de grandeurs de réglage selon une ou plusieurs des revendications 4 à 5, **caractérisé en ce que** le modèle sous-jacent comprend de plus l'équation suivante :

$$\dot{x}_6 : \frac{d}{dt}(v_{Me}) = p_F \dot{P}_{ind} \cdot (R_F)^{w_F} \cdot \left(f_0 - \frac{f_0}{f_1} h_F\right)$$
$$+ p_F P_{ind} \cdot w_F \dot{R}_F (R_F)^{w_F - 1} \cdot \left(f_0 - \frac{f_0}{f_1} h_F\right)$$
$$+ p_F P_{ind} \cdot (R_F)^{w_F} \cdot \left(-\frac{f_0}{f_1} \dot{h}_F\right)$$

dans lequel les paramètres $f_0$ (de 0,001 à 30 mm), $f_1$ (de 0,001 à 30 mm), $p_F$ (de 0,00001 à 2 (kWs)$^{-1}$) et $w_F$ (de 0 à 2, sans dimension) représentent des paramètres individuels du modèle.

7. Procédé de production régulée de corps conformés cristallins dans le procédé de la zone fondue par influence de grandeurs de réglage selon une ou plusieurs des revendications 4 à 6, **caractérisé en ce que** le modèle sous-jacent comprend de plus l'équation suivante :

$$\dot{x}_7 : \frac{d}{dt}(v_{Cr}) = -p_C \dot{P}_{ind} \cdot (R_C)^{w_C} \cdot \left(c_0 - \frac{c_0}{c_1} h_C\right)$$
$$- p_C P_{ind} \cdot w_C \dot{R}_C (R_C)^{w_C - 1} \cdot \left(c_0 - \frac{c_0}{c_1} h_C\right)$$
$$- p_C P_{ind} \cdot (R_C)^{w_C} \cdot \left(-\frac{c_0}{c_1} \dot{h}_C\right)$$

dans lequel les paramètres $c_0$ (de 0,001 à 30 mm), $c_1$ (de 0,001 à 30 mm), $p_C$ (de 0,00001 à 2 (kWs)$^{-1}$) et $w_C$ (de 0 à 2, sans dimension) représentent des paramètres individuels du modèle.

8. Procédé de production régulée de corps conformés cristallins dans le procédé de la zone fondue par influence de grandeurs de réglage selon une ou plusieurs des revendications 4 à 7, **caractérisé en ce que** le modèle sous-jacent comprend de plus l'équation suivante :

$$\dot{x}_8 : \frac{d}{dt}(\varphi_C) = a_V \cdot k_V \cdot \dot{V}_v + a_R \cdot k_R \cdot \dot{R}_C + a_h \cdot k_h \cdot \dot{h}_C$$

dans lequel les paramètres sont

$a_V$ : un facteur de correction angulaire = de 0 à 3
$a_R$ : un facteur de correction angulaire = de 0 à 3
$a_h$ : un facteur de correction angulaire = de 0 à 3
$k_V$ : un facteur fonction du rayon du cristal $R_C$ compris entre 3 et 0,0001°/mm$^3$ pour $R_C$ compris entre 1 et 100 mm
$k_R$ : un facteur fonction du rayon du cristal $R_C$ compris entre -80 et -1°/mm pour $R_C$ compris entre 1 et 100 mm
$k_h$ : un facteur fonction du rayon du cristal $R_C$ compris entre -60 et -0,01°/mm pour $R_C$ compris entre 1 et 100 mm.

9. Procédé de production régulée de corps conformés cristallins dans le procédé de la zone fondue par influence de grandeurs de réglage selon une ou plusieurs des revendications 4 à 8, **caractérisé en ce que** le modèle sous-jacent comprend de plus les équations suivantes :

$$\dot{x}_9 : \frac{d}{dt}(P_{ind}) = \frac{1}{\tau_P}\left(K_P P_{gen} - P_{ind}\right)$$

$$x_{10}: \frac{d}{dt}(\alpha_F) = 0$$

dans lequel les paramètres sont

$K_P$ : transfert de puissance = de 0 à 1 (sans dimension) et
$\tau_P$ : constante de temps = de 0,1 s à 60 s.

**10.** Procédé de production régulée de corps conformés cristallins dans le procédé de la zone fondue par influence de grandeurs de réglage selon une ou plusieurs des revendications 1 à 9, **caractérisé en ce qu'**au moins une des valeurs réelles de l'état du système, parmi le rayon du cristal ($R_C$), le rayon du barreau d'alimentation ($R_F$), l'angle du cristal ($\varphi_C$), la hauteur de la zone supérieure ($h_F$), la hauteur de la zone inférieure ($h_C$), le volume (visible) de fusion ($V_v$), l'angle du barreau d'alimentation ($\alpha_F$), est mesurée et éventuellement filtrée par un observateur d'état.

**11.** Procédé de production régulée de corps conformés cristallins dans le procédé de la zone fondue par influence de grandeurs de réglage selon une ou plusieurs des revendications 1 à 10, **caractérisé en ce que** les valeurs réelles des états du système de vitesse du front de fusion ($v_{Me}$) et/ou de vitesse du front de cristallisation ($v_C$) sont mesurées indirectement avec un observateur d'état à partir des valeurs d'état du système mesurées directement.

**12.** Procédé de production régulée de corps conformés cristallins dans le procédé de la zone fondue par influence de grandeurs de réglage selon une ou plusieurs des revendications 1 à 11, **caractérisé en ce que** la valeur réelle de l'état du système de puissance d'induction ($P_{ind}$) est mesurée indirectement avec un observateur d'état à partir des valeurs d'état du système mesurées directement.

**13.** Procédé de production régulée de corps conformés cristallins dans le procédé de la zone fondue par influence de grandeurs de réglage selon la revendication 10 ou 12, **caractérisé en ce que** l'observateur d'état est un filtre de Kalman.

**14.** Procédé de production régulée de corps conformés cristallins dans le procédé de la zone fondue par influence de grandeurs de réglage selon une ou plusieurs des revendications 1 à 13, **caractérisé en ce que** le corps conformé cristallin produit est un monocristal de silicium.

Fig. 1

**Fig. 2**

Vorratsstab

Tropfen

Vorlauf

Dünnhals

Konus

Zylinder

Induktor

Impfkristall

1  2  3  4  5

**Fig. 3**

23

Kamerasystem <u>2</u> → Messwerterfassung <u>3</u>

Messgrößen <u>4</u>

Regler <u>5</u>

Zustandsbeobachter <u>6</u>

Systemzustände <u>7</u>

Zonenschmelz-
Anlage
<u>1</u>

Stellgrößen
aus Leitsystem
<u>12</u>

Optimierung der
Stellgrößen
<u>8</u>

Reglervorgaben <u>9</u>

optimierte Stellgrößen <u>10</u>

Leitsystem <u>11</u>

Stellgrößen
aus Leitsystem
<u>12</u>

**Fig. 4**

Fig. 5

Fig. 6

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3060123 A
- US 3757071 A
- DE 2659194
- EP 0821082 A

**In der Beschreibung aufgeführte Nicht-Patentliteratur**

- Modelling the dynamics and control design for Czochralski, Liquid Encapsulated Czochralski and Floating Zone processes. **ARTIKEL ; G. SATUNKIN.** Progress in Crystal Growth and Characterization of Materials. 2010, vol. 56, 1-121